# EUROPEAN PATENT APPLICATION

(11) **EP 3 611 937 A1**
(43) Date of publication of application: **19.02.2020**
(21) Application number: 17905826.8
(22) Date of filing: 12.04.2017
(51) Int. Cl.: H04R 3/12

(54) **INFORMATION PROCESSING DEVICE, INFORMATION PROCESSING METHOD, AND PROGRAM**

(71) Applicant: Yamaha Corporation, Hamamatsu-shi, Shizuoka 430-8650 (JP)
(72) Inventor: KAWAI, Hironari, Hamamatsu-shi Shizuoka 430-8650 (JP)
(74) Representative: Hoffmann Eitle
(86) International application number: PCT/JP2017/014902
(87) International publication number: WO 2018/189819

(57) **Abstract**

An information processing device includes a display processing portion and a communication processing portion. The display processing portion simultaneously displays a switching reception portion (Op1) and a selection reception portion (Op2) on the same screen (F). Then, the switching reception portion (Op1) receives switching of a speaker to be a supply destination of a signal from a signal processing device. The selection reception portion (Op2) receives a selection about whether or not the characteristics of the speaker to be selected by the switching received by the switching reception portion (Op1) are optimized. The communication processing portion transmits instructions for various settings received by the switching reception portion (Op1) and the selection reception portion (Op2) to the signal processing device.

## Description

### Technical Field

A preferred embodiment of the present invention relates to a user interface to set up various types of processing to be performed in a signal processing device such as an amplifier.

### Background Art

An AV (Audio Visual) amplifier may reproduce sound using all speakers connected to the amplifier. In addition, a HiFi (Hi Fidelity) amplifier may be able to use a speaker by switching speakers according to a sound source (classic or rock, for example) to be reproduced. Then, various methods have been proposed as technology to measure speaker characteristics and optimize the speaker characteristics using a measurement result (see Patent Literature 1, for example).

### Citation List

### Patent Literature

Patent Literature 1: Unexamined Japanese Patent Publication No. 2015-84584

### Summary of the Invention

### Technical Problem

However, even when such optimization technology disclosed in Patent Literature 1 is applied to an amplifier that is able to switch a speaker, a user may make a fine adjustment with a switch, a knob, or the like for a detailed setting that is provided in the amplifier in order to suit own preference. On the other hand, in the HiFI amplifier, in order to prioritize sound quality, a detailed setting that is able to be finely adjusted with a switch, a knob, or the like is limited to a portion in many cases. Therefore, even when the user desires to suit the own preference, the setting operation has had a limit. In addition, the operation with a switch, a knob, or the like is required for each switching of a speaker, and forces a complicated operation upon a user.

In view of the foregoing, an object of a preferred embodiment of the present invention is to provide an information processing device that facilitates an operation to optimize characteristics of a speaker at each switching of a speaker.

### Solution to Problem

An information processing device according to a preferred embodiment of the present invention includes a display processing portion and a communication processing portion. The display processing portion simultaneously displays a switching reception portion and a selection reception portion on the same screen. Then, the switching reception portion receives switching of a speaker to be a supply destination of a signal from a signal processing device. The selection reception portion receives a selection about whether or not the characteristics of the speaker to be selected by the switching received by the switching reception portion are optimized. The communication processing portion transmits instructions for various settings received by the switching reception portion and the selection reception portion to the signal processing device.

### Advantageous Effects of Invention

According to a preferred embodiment of the present invention, an operation to optimize the characteristics of a speaker at each switching of a speaker becomes easy for a user.

### Brief Description of Drawings

FIG. 1 is a block diagram conceptually showing a configuration of a signal processing device that is able to be operated by an information processing device according to a first preferred embodiment.
FIG. 2 is a conceptual diagram showing an application example of the information processing device and the signal processing device.
FIG. 3 is a flow chart showing processing to obtain an optimal setting to be performed by the signal processing device.
FIG. 4 is a block diagram conceptually showing a configuration of the information processing device according to the first preferred embodiment.
FIGs. 5(A) and (B) are conceptual diagrams showing a screen for reproduction settings to be displayed by the information processing device.
FIG. 6 is a flow chart showing information processing to be performed in a control portion of the information processing device in the first preferred embodiment.
FIG. 7 is a flow chart showing reproduction processing to be performed by the signal processing device.
FIGs. 8(A) and (B) are conceptual diagrams showing a screen for reproduction settings in a second preferred embodiment.

### Detailed Description of Preferred Embodiments

### [1] First Preferred Embodiment

### [1-1] Configuration of Signal Processing Device

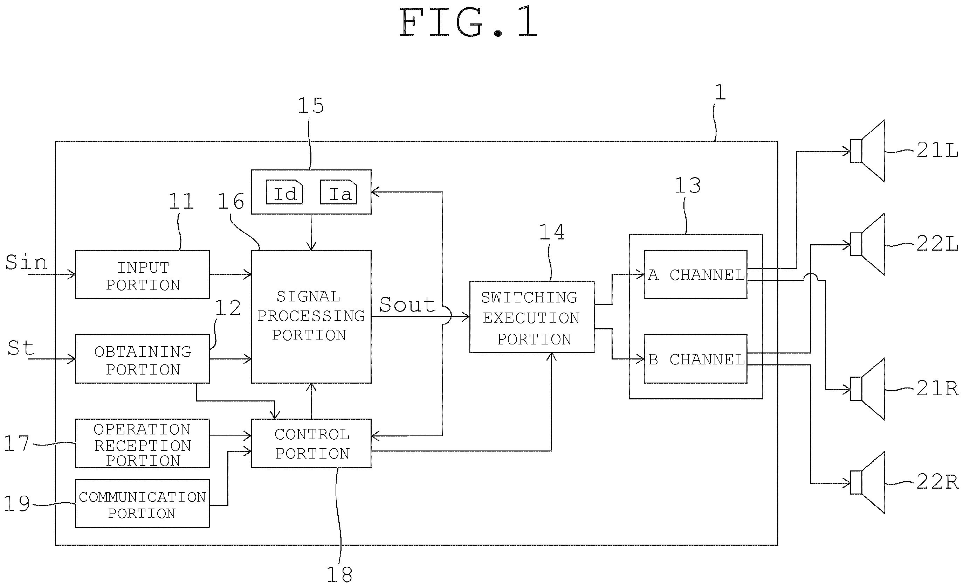

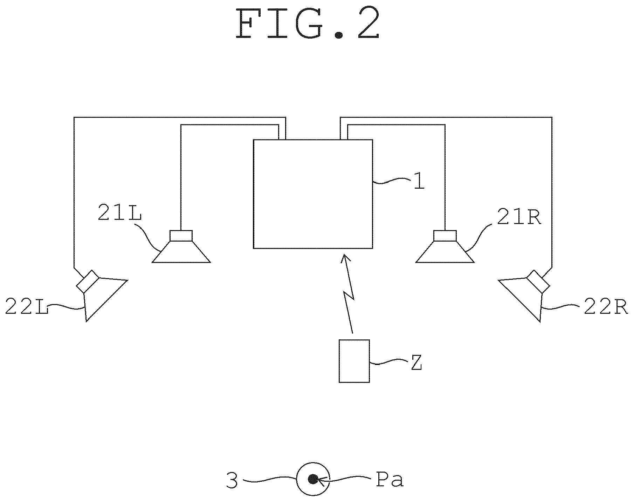

FIG. 1 is a block diagram conceptually showing a configuration of a signal processing device 1 that is able to be operated by an information processing device Z according to a first preferred embodiment. In addition, FIG. 2 is a conceptual diagram showing an application example of the information processing device Z and the signal processing device 1. As shown in FIG. 1, the signal processing device 1 includes an input portion 11, an obtaining portion 12, an output portion 13, a switching execution portion 14, a storage portion 15, a signal processing portion 16, an operation reception portion 17, a communication portion 19, and a control portion 18 that collectively controls the portions.

The input portion 11 is an interface to be used for inputting an audio signal to the signal processing device 1. In the present preferred embodiment, the audio signal to be inputted to the signal processing device 1 is an audio signal to be inputted from a reading device (not shown) such as a CD player, a DVD player, an LD player. Hereinafter, this audio signal is referred to as an "input audio signal Sin."

Specifically, the input portion 11 has an interface that receives an input of a digital audio signal, such as HDMI (registered trademark) (High-Definition Multimedia Interface) or S/PDIF (Sony Philips Digital Interface). The interface is connected to a CD player or the like. The input portion 11 further has an interface that receives an input of an analog audio signal. The interface is connected to an LD player or the like. It is to be noted that the input portion 11 may incorporate an ADC (Analog to Digital Converter) that converts an inputted analog audio signal into a digital signal.

The obtaining portion 12 is an interface that receives an input of a sound signal to the signal processing device 1. The obtaining portion 12 is connected to a microphone 3 (see FIG. 2), and sound inputted to the microphone 3 is converted into a sound signal by the microphone 3 and is inputted to the obtaining portion 12. It is to be noted that the sound signal may be an analog signal or may be a digital signal. In a case in which the sound signal is an analog signal, the obtaining portion 12 may incorporate an ADC that converts a sound signal to a digital signal.

The output portion 13 is an interface to be used for outputting an audio signal to a speaker. In the present preferred embodiment, the audio signal to be outputted to the speaker is an audio signal on which signal processing has been performed by the signal processing portion 16, as described later. Hereinafter, this audio signal is referred to as an "output audio signal Sout."

In the present preferred embodiment, the output portion 13 includes an A channel and a B channel as an output channel to be connected to a speaker. As an example, the A channel is connected to a pair of speakers 21L and 21R, and the B channel is connected to a pair of speakers 22L and 22R.

The switching execution portion 14 is a switch circuit, for example, and selectively switches a speaker to be connected to the signal processing portion 16, out of the A channel and the B channel, according to a switching executing instruction, from the control portion 18. Specifically in the switching execution portion 14, it is possible to execute switching to select only the A channel, switching to select only the B channel, and switching to select both the A channel and the B channel.

The communication portion 19 enables communication with the information processing device Z, and includes, for example, a communication machine that enables short-distance wireless communication with the information processing device Z, an interface that enables communication with the information processing device Z through a network, or the like. The communication portion 19 includes a receiving portion and receives various instructions from the information processing device Z. Then, switching instruction to switch a speaker is inputted to the control portion 18 through the communication portion 19, so that switching of a speaker is executed through control of the switching execution portion 14 by the control portion 18. It is to be noted that the switching instruction may be inputted from the operation reception portion 17 of the signal processing device 1. In addition, the communication portion 19 may include a transmitting portion that transmits various signals to the information processing device Z. Furthermore, the communication portion 19 may be configured as a portion of the operation reception portion 17.

In a case in which only the A channel has been selected by the switching instruction, only the pair of the speakers 21L and 21R connected to the A channel is used as a supply destination of an output audio signal Sout. In a case in which only the B channel has been selected by the switching instruction, only the pair of the speakers 22L and 22R connected to the B channel is used as a supply destination of the output audio signal Sout. In a case in which both the A channel and the B channel have been selected by the switching instruction, all the speakers 21L, 21R, 22L, and 22R connected to these channels are used as a supply destination of the output audio signal Sout.

In other words, the switching of a speaker to be a supply destination of the output audio signal Sout is executed by the switching execution portion 14 according to the switching instruction to be inputted from the information processing device Z.

It is to be noted that the switching execution portion 14, as not only a switch circuit but as an execution portion of the control portion 18, may internally execute the switching (switching of an output channel) of a speaker according to the switching instruction from a user. Such an execution portion is also able to be applied in a case an output audio signal Sout is wirelessly supplied from the signal processing device 1 to a speaker.

The storage portion 15 stores a default setting Id for achieving default signal processing, as data. The default setting Id includes a setting for equalizing balance between left and right speakers and a setting for flattening frequency characteristics (F characteristics), for example. As an example, the default setting Id includes various settings (settings of successive model specifications) that have been used without being greatly changed from successive models of amplifiers or the like.

The storage portion 15 further stores an optimal setting Ia as data by associating the setting with the switching (only the A channel, only the B channel, the A channel + the B channel) of a speaker. The optimal setting Ia corresponds to a measurement result obtained by measuring the characteristics (speaker characteristics) of a speaker to be selected by the switching of a speaker. Specifically, the optimal setting Ia includes various settings (a setting of a distance to a speaker, a setting of a volume level, a setting of an output timing (delay), and the like) for optimizing the speaker characteristics according to the switching of a speaker.

In the present preferred embodiment, the default setting Id and the optimal setting Ia that are stored in the storage portion 15, when a selection instruction from a user to select whether or not the speaker characteristics are optimized is received by the signal processing device 1, are selectively read out by the signal processing portion 16 according to the selection instruction. The selection instruction is inputted by the user in the information processing device Z, and is inputted to the signal processing device 1 through the communication portion 19. It is to be noted that the selection instruction may be inputted from the operation reception portion 17 of the signal processing device 1.

In addition, the optimal setting Ia stored in the storage portion 15 is rewritable. Specifically, a change instruction from the user for changing the optimal setting Ia is received by the signal processing device 1, so that the optimal setting Ia is rewritten according to the change instruction. The change instruction is inputted by the user in the information processing device Z, and is inputted to the signal processing device 1 through the communication portion 19. It is to be noted that the change instruction may be inputted from the operation reception portion 17 of the signal processing device 1.

The optimal setting Ia to be stored in the storage portion 15 is obtained based on the following processing is performed by the signal processing device 1.

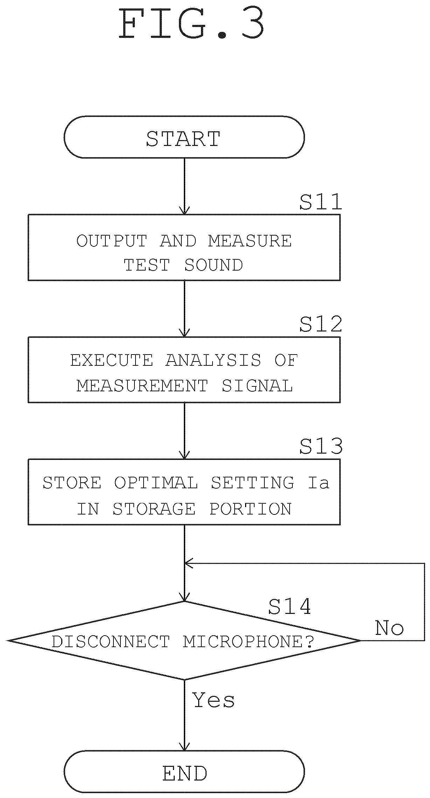

FIG. 3 is a flow chart showing processing to obtain the optimal setting Ia. The processing starts when the signal processing device 1 detects connection of the microphone 3 to the obtaining portion 12 or when an instruction to start measurement are received from a user. At this time the microphone 3 is placed in a listening position Pa by the user (see FIG. 2). After the start of the control processing, the signal processing device 1 emits a test sound from the speaker selected by the switching of a speaker and also measures the test sound by the microphone 3 in the listening position Pa (Step S11). Next, the signal processing device 1 derives various settings for optimizing speaker characteristics by analyzing a signal obtained by the measurement (Step S12). Subsequently, the signal processing device 1 stores in the storage portion 15 various settings derived in Step S12 as an optimal setting Ia (Step S13). Subsequently, when the signal processing device 1 detects that the microphone 3 is disconnected from the obtaining portion 12 (Step S14), the processing for obtaining the optimal setting Ia ends. It is to be noted that the processing may end when the processing is executed for all the switching and the optimal setting Ia corresponding to each switching is completed to be obtained. It is to be also noted that processing such as measurement for obtaining the optimal setting Ia may be executed by remote control using the information processing device Z, for example.

The signal processing portion 16 is a DSP (Digital Signal Processor), for example, and selectively reads out data of any one of the default setting Id and the optimal setting Ia from the storage portion 15 according to a readout execution instruction, from the control portion 18. Then, the signal processing portion 16 performs signal processing of an input audio signal Sin using readout data.

In a case in which the input audio signal Sin is processed using the default setting Id, an output audio signal Sout on which various settings in the default setting Id are reflected is obtained. Then, this output audio signal Sout is supplied to a speaker, so that default sound is outputted. In addition, in a case in which the input audio signal Sin is processed using the optimal setting Ia, an output audio signal Sout on which various settings in the optimal setting Ia are reflected is obtained. Then, this output audio signal Sout is supplied to a speaker, so that optimized sound is outputted.

The operation reception portion 17 is a user interface for receiving various operation instructions from a user. It is to be also noted that the operation reception portion 17 may include a display portion for showing a variety of information to a user.

The control portion 18 integrally controls the signal processing device 1 and includes a processing device such as a CPU (Central Processing Unit) and a microcomputer. In the present preferred embodiment, the control portion 18 performs various processing mainly according to an operation instruction received in the operation reception portion 17 and the communication portion 19. It is to be also noted that processing that the control portion 18 performs is achieved through the control portion 18 executes a program corresponding to the processing. Such a program may be stored in a readable storage medium (a flash memory or the like, for example) or may be stored in the storage portion 15.

It is to be also noted that the switching of a speaker according to the present invention is not limited to the above aspect and may be another aspect. For example, one aspect of the switching of a speaker according to the present invention includes switching of a speaker connected by the bi-wiring method, switching of a speaker connected to the signal processing device 1 capable of broadcasting multichannel, and switching of a speaker including a subwoofer. In addition, switching of a speaker in a configuration in which an output audio signal Sout is wirelessly supplied to a speaker is also one aspect. Furthermore, switching between bi-amping and single-amping with respect to two amplifiers is also one aspect.

### [1-2] Configuration of Information Processing Device

The information processing device Z is a device different from the signal processing device 1, and functions as a user interface for setting various processing (hereinafter referred to as "reproduction settings") to be performed by the signal processing device 1. The information processing device Z, for example, is a portable terminal such as a smartphone in which application for reproduction settings is installed. It is to be also noted that the information processing device Z may be an exclusive terminal such as a remote controller.

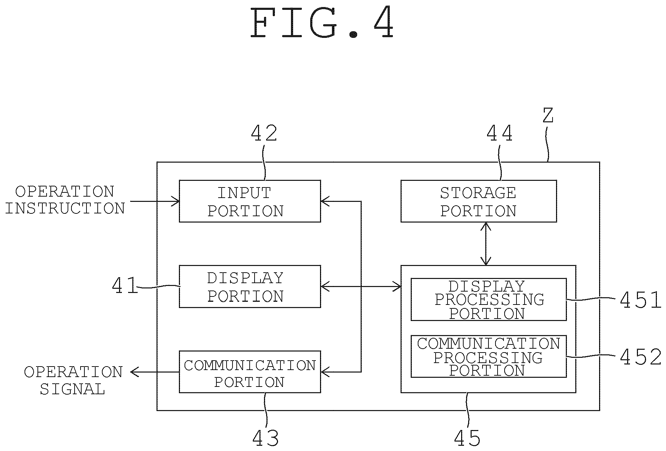

FIG. 4 is a block diagram conceptually showing a configuration of the information processing device Z according to the first preferred embodiment. As shown in FIG. 4, the information processing device Z includes a display portion 41, an input portion 42, a communication portion 43, a storage portion 44, and a control portion 45.

The display portion 41 is a display panel such as a liquid crystal panel and an EL panel, for example, and shows a user a variety of information.

The input portion 42 is a touch panel formed on a screen of the display portion 41, and detects a position on the touch panel that the user has touched with a finger. A detection result of the position by the input portion 42 is supplied to the control portion 45, and the control portion 45 receives an operation instruction (including a switching instruction, a change instruction, and a selection instruction) from the user according to the detection result. It is to be also noted that the input portion 42 may include an operation portion such as an operation button and an operation key.

The communication portion 43 enables communication with the signal processing device 1, and is, for example, a communication machine that enables short-distance wireless communication with the signal processing device 1, or an interface that enables communication with the signal processing device 1 through a network. The communication portion 43 includes a transmitting portion, and transmits the various operation instructions (including a switching instruction, a change instruction, and a selection instruction) that the input portion 42 has received, to the signal processing device 1. It is to be also noted that the communication portion 43 may include a receiving portion that receives various signals from the signal processing device 1.

The control portion 45 integrally controls the information processing device Z and includes a processing device such as a CPU and a microcomputer. In the present preferred embodiment, the control portion 45 includes a display processing portion 451 and a communication processing portion 452, and performs information processing that causes the information processing device Z to function as a user interface for reproduction settings for the signal processing device 1. It is to be also noted that the information processing that the control portion 45 performs is achieved through the control portion 45 executes a program corresponding to the processing. Such a program may be stored in a readable storage medium (a flash memory or the like, for example) or may be stored in the storage portion 44.

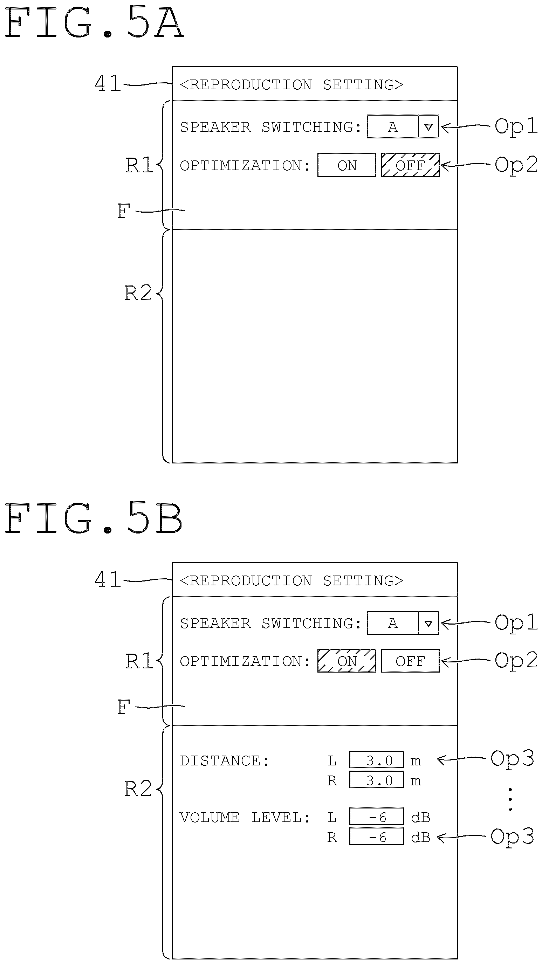

FIGs. 5(A) and (B) are conceptual diagrams showing a screen F for reproduction settings to be displayed on the display portion 41. As shown in FIGs. 5(A) and (B), in a case which the information processing device Z functions as the user interface for reproduction settings, the display portion 41 simultaneously displays a switching reception portion Op1 and a selection reception portion Op2 and selectively displays a detailed setting reception portion Op3.

Each of the switching reception portion Op1, the selection reception portion Op2, and the detailed setting reception portion Op3 is a physical controller displayed on the display portion 41. In the present preferred embodiment, the physical controller includes a switch, a button, a knob, or a dial that is displayed as an image on the screen F displayed on the display portion 41, and enables an input of various instructions (such as a switching instruction, a selection instruction, and a change instruction) by a user. It is to be also noted that the physical controller may enable an input of a number, a character, or the like. Then, the image configuring a physical controller is stored in the storage portion 44, for example, and is properly read out by the control portion 45. The same applies to the following.

The switching reception portion Op1 receives switching of a speaker to be a supply destination of an output audio signal Sout according to an input of a switching instruction by a user (see FIG. 5 (A)).

The selection reception portion Op2 receives a selection about whether or not speaker characteristics are optimized (optimization "ON" or "OFF") according to an input of a selection instruction by a user (see FIG. 5 (A)). Specifically, the selection reception portion Op2 receives a selection about whether or not the optimal setting Ia associated with the switching received by the switching reception portion Op1 is used, in processing of the output audio signal Sout in the signal processing portion 16.

The detailed setting reception portion Op3 receives a change by the user about at least one detailed setting included in the optimal setting Ia according to an input of a change instruction by a user (see FIG. 5(B)). In the present preferred embodiment, the optimal setting Ia includes various detailed settings such as a setting of a distance to a speaker, a setting of a volume level, and a setting of an output timing (delay), for example. A physical controller that enables various detailed settings to be changed by a user is displayed on the display portion 41 as a detailed setting reception portion Op3. It is to be also noted that, in FIG. 5(B), as an example of the detailed setting reception portion Op3, a physical controller for changing a setting of a distance to a speaker and a physical controller for changing a setting of a volume level are shown.

The display processing portion 451 displays the screen F by controlling the display portion 41, and changes a display on the screen F according to the settings received in each of the switching reception portion Op1, the selection reception portion Op2, and the detailed setting reception portion Op3. For example, in the switching reception portion Op1 (the switching of a speaker), the display is changed from "A," to "B" or "A+B" or the like. In the selection reception portion Op2 (selection of optimization), the display is changed from selection of "OFF" to selection of "ON." In addition, a numerical value to be displayed is changed in the detailed setting reception portion Op3. The details of display processing (a portion of the information processing to be performed in the information processing device Z) that the display processing portion 451 performs will be described later.

The communication processing portion 452 performs processing for transmitting the operation instructions for the various settings received by the switching reception portion Op1, the selection reception portion Op2, and the detailed setting reception portion Op3, to the signal processing device 1. The details of transmitting processing (a portion of information processing to be performed in the information processing device Z) that the communication processing portion 452 performs will be described later.

### [1-3] Control in Information Processing Device

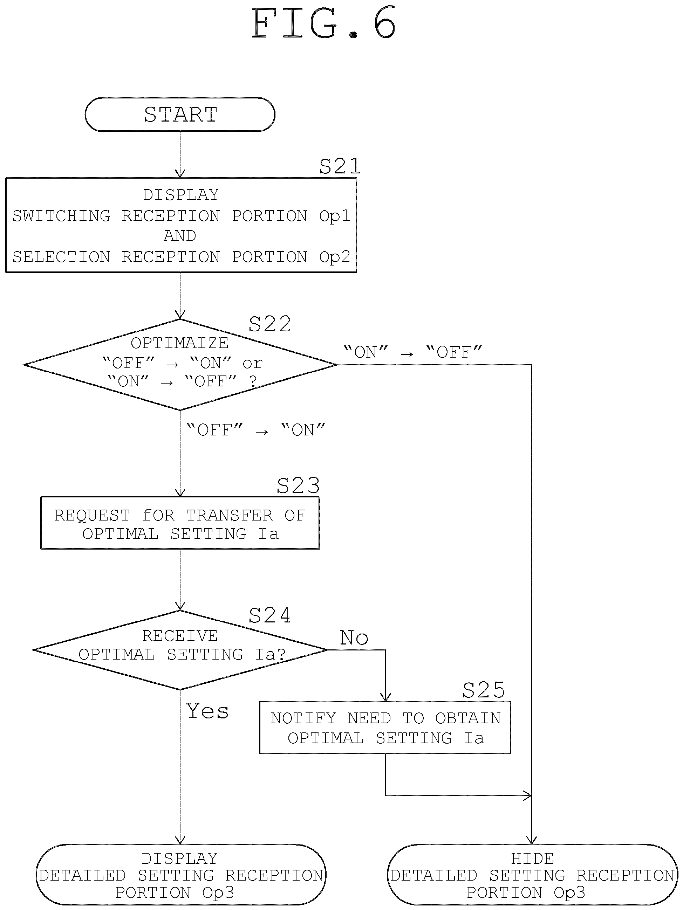

FIG. 6 is a flow chart showing information processing to be performed in the control portion 45. The information processing is performed, for example, when the application for reproduction settings installed in the information processing device Z is started or when the application for reproduction settings provided from the signal processing device 1 is started. It is to be noted that, in the following information processing, the operation instructions for the various settings received by the switching reception portion Op1, the selection reception portion Op2, and the detailed setting reception portion Op3, may be transmitted to the signal processing device 1 each time being received or may be collectively transmitted when a transmitting instruction is inputted from a user, for example.

When the information processing is started in the control portion 45, the display processing portion 451, by controlling the display portion 41, simultaneously displays the switching reception portion Op1 and the selection reception portion Op2 on the same screen F (a user interface) for reproduction settings (Step S21. See FIG. 5(A)). At this time, the display processing portion 451 displays the switching reception portion Op1 and the selection reception portion Op2 on a first display region R1 within the screen F. In the present preferred embodiment, the first display region R1, in the screen F, is a region in which the physical controller such as the switching reception portion Op1 is always displayed.

As an example, the display processing portion 451, when displaying the selection reception portion Op2 in the first display region R1 within the screen F, displays the selection reception portion Op2, in a state in which the optimization "OFF" is selected. At this time, the display processing portion 451 hides the detailed setting reception portion Op3 and other portions in a second display region R2 within the screen F (see FIG. 5(A)). It is to be noted that the display processing portion 451, in the second display region R2, instead of hiding the detailed setting reception portion Op3, may cause the detailed setting reception portion Op3 to be in a state in which the operation is disabled. In the present preferred embodiment, the second display region R2, in the screen F, is a region in which switching of display and non-display (or disabling) of the physical controller such as the detailed setting reception portion Op3 is performed.

As another example, the display processing portion 451, when displaying the selection reception portion Op2 in the first display region R1 within the screen F, displays the selection reception portion Op2, in a state in which the optimization "ON" is selected. At this time, the display processing portion 451 displays the detailed setting reception portion Op3 in the second display region R2 within the screen F (see FIG. 5(B)).

Next, the control portion 45, when the selection reception portion Op2 is operated, determines which change of a change ("OFF" to "ON") to optimization "ON" and a change ("ON" to "OFF") to optimization "OFF" has been made (Step S22). Then, the control portion 45, when determining that the change ("OFF" to "ON") to optimization "ON" is made in Step S22, requests the signal processing device 1 to transfer the optimal setting Ia to the information processing device Z (Step S23). Specifically, the communication processing portion 452 transmits a transfer request signal to the signal processing device 1 through the communication portion 43. In the present preferred embodiment, the transfer request signal includes the information (switching information) that indicates which switching is received in the switching reception portion Op1, and is a signal to request the optimal setting Ia associated with switching that the switching information indicates to be transferred to the information processing device Z.

When the signal processing device 1 receives a transfer request from the information processing device Z, the signal processing device 1 reads out the optimal setting Ia corresponding to the switching information in a transmitted transfer request signal from the storage portion 15, and transfer the optimal setting Ia to the information processing device Z. At this time, in a case in which the storage portion 15 has no optimal setting Ia, the signal processing device 1 provides notification as such to the information processing device Z.

When the information processing device Z receives the optimal setting Ia transferred from the signal processing device 1 (in the case of "Yes" in Step S24), the display processing portion 451 displays the detailed setting reception portion Op3 on the same screen F that displays the switching reception portion Op1 and the selection reception portion Op2 (see FIG. 5(B)). At this time, the display processing portion 451 displays the detailed setting reception portion Op3 on the second display region R2 within the screen F, in a state in which content of various detailed settings included in the transferred optimal setting Ia has been reflected.

In the present preferred embodiment, the first display region R1 and the second display region R2 are regions divided by two in the screen F. Therefore, on the screen F, the physical controllers (the switching reception portion Op1 and the selection reception portion Op2) that are always displayed are collected in the first display region R1, and the physical controller (the detailed setting reception portion Op3) in which the switching of display and non-display (or disabling) is performed is collected in the second display region R2. Therefore, the user interface (the screen F) for reproduction settings is easy to view for a user.

After Step S23 (the transfer request), in a case in which the information processing device Z receives the notification that there is no optimal setting Ia, from the signal processing device 1 (in the case of "No" in Step S24), the control portion 45 provides notification that it is necessary to obtain the optimal setting Ia, to a user (Step S25). This notification is provided mainly by the display of the content of the notification to the display portion 41, for example.

When the control portion 45 determines that the change ("ON" to "OFF") to optimization "OFF" is made in Step S22, the display processing portion 451 hides (or disables) the detailed setting reception portion Op3 on the screen F (see FIG. 5(A)).

Then, a user operates switching, selection, change, and the like of the various settings on the screen F, so that operated content is transmitted to the signal processing device 1 by the communication processing portion 452 as an operation instruction (including a switching instruction, a change instruction, and a selection instruction) from a user.

When the signal processing device 1 receives the operation instruction transmitted from the information processing device Z, the control portion 18 changes the various settings according to the operation instruction. Specifically, the control portion 18 causes the switching execution portion 14 to execute the switching of a speaker according to the switching instruction. In addition, the control portion 18 determines which of the default setting Id and the optimal setting Ia that are stored in the storage portion 15 is to be read out by the signal processing portion 16 according to the selection instruction. Furthermore, the control portion 18 rewrites the optimal setting Ia in the storage portion 15 according to the change instruction. Specifically, the control portion 18 rewrites various detailed settings in the optimal setting Ia to content instructed by the change instruction.

According to the information processing device Z of the present preferred embodiment, the switching reception portion Op1 and the selection reception portion Op2 are collectively displayed on the same screen F (the user interface) for reproduction settings. Therefore, for a user, it becomes possible to easily perform on one screen F an input (an input from the switching reception portion Op1) of the switching instruction to switch a speaker, and an input (an input from the selection reception portion Op2) of the selection instruction to select whether or not speaker characteristics are optimized.

Furthermore, when the selection of optimization "ON" is received by the selection reception portion Op2 by the input of the selection instruction, the detailed setting reception portion Op3 is displayed on the same screen F on which the switching reception portion Op1 and the selection reception portion Op2 are displayed. Therefore, the user can change the detailed settings included in the optimal setting Ia, without changing the screen. Accordingly, an operation to optimize the characteristics of a speaker at each switching of a speaker becomes easy for a user.

### [1-4] Control in Signal Processing Device

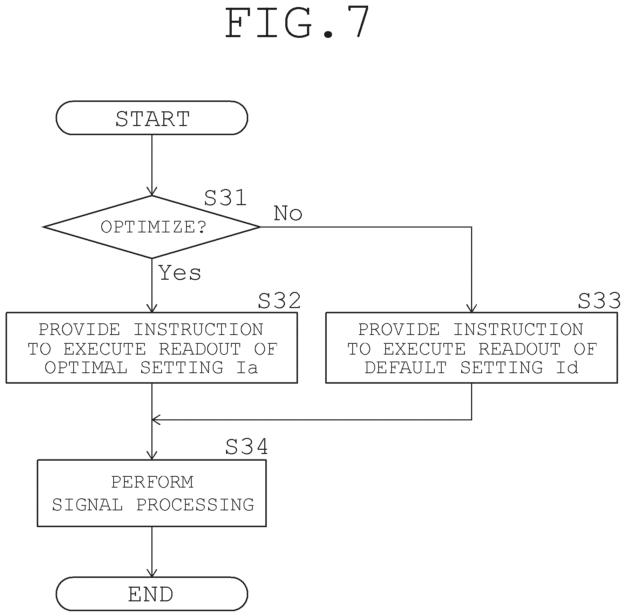

FIG. 7 is a flow chart showing reproduction processing to be performed by the signal processing device 1. The reproduction processing is started at a timing when an operation instruction (including a switching instruction, a selection instruction, and a change instruction) is inputted from the information processing device Z. It is to be noted that, at such a timing as when electric power is supplied to the signal processing device 1 (when the power supply is ON) or when the microphone 3 is disconnected from the obtaining portion 12, in FIG. 7, Step S32 or S33 may be executed without Step S31. In addition, when electric power is supplied to the signal processing device 1 in a state in which the microphone 3 is connected to the obtaining portion 12, processing for obtaining the optimal setting Ia stated above may be performed before the reproduction processing is performed.

When the reproduction processing is started, the control portion 18 determines whether or not the speaker characteristics are optimized according to the selection instruction (Step S31). Then, the control portion 18, when determining "optimize (Yes)" in Step S31, causes the signal processing portion 16 to read out from the storage portion 15 the optimal setting Ia associated with the switching of a speaker that the switching instruction indicates (Step S32). On the other hand, the control portion 18, when determining "not optimize (No)" in Step S31, causes the signal processing portion 16 to read out from the storage portion 15 the default setting Id (Step S33).

Subsequently, the signal processing portion 16 performs signal processing of an input audio signal Sin to be inputted (Step S34). Accordingly, the signal processing portion 16 performs the signal processing of the input audio signal Sin using readout data (the default setting Id or the optimal setting Ia) from the storage portion 15. The output audio signal Sout to be obtained by the signal processing is supplied to the output channel connected through the switching execution portion 14, as necessary.

According to such reproduction processing, the control portion 18, after having once performed to obtain (see FIG. 3) corresponding optimal setting Ia, in each switching of a speaker that is able to be received by the switching reception portion Op1, unless the change instruction or the like (connection of the microphone 3 to the obtaining portion 12 in the present preferred embodiment) to change the optimal setting Ia is received, causes the signal processing portion 16 to perform signal processing using the same optimal setting Ia stored in the storage portion 15. Therefore, according to the switching of a speaker, it becomes possible to automatically optimize the characteristics (speaker characteristics) of a speaker to be selected by the switching.

In addition, even after the optimal setting Ia is obtained in the signal processing device 1, it becomes possible to restore the setting to the default setting Id to which any change is not added at all, and to reproduce sound. In other words, a user can select either an output of optimized sound or an output of default sound when reproducing sound.

### [2] Second Preferred Embodiment

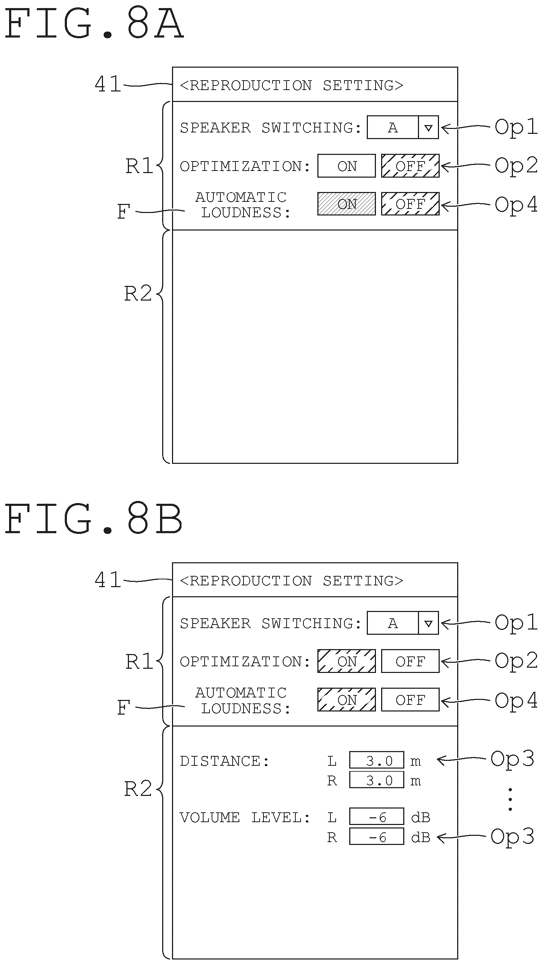

FIGs. 8(A) and (B) are conceptual diagrams showing a screen F for reproduction settings to be displayed on the display portion 41, in a second preferred embodiment. As shown in FIGs. 8(A) and (B), the information processing device Z may further display a second selection reception portion Op4 on the screen F (a user interface) for reproduction settings.

The second selection reception portion Op4 is one of the physical controllers to be displayed on the display portion 41, and, according to an input of a selection instruction by a user, receives a selection (that is, automatic or manual selection) of whether or not loudness correction is automatically performed (automatic loudness "ON" or "OFF"). In the present preferred embodiment, the loudness correction is to achieve the frequency characteristics on the basis of the equal loudness contour (ISO226:2003), for example, and a loudness correction value (loudness volume) is adjusted so that difference in the sound pressure level between a middle frequency audio component and a high frequency audio component or a low frequency audio component may be increased. For example, in a case in which a loudness correction value is 0 dB, the frequency characteristics are flat, and, as the loudness correction value becomes small, the sound pressure level of the middle frequency audio component is reduced, which increases the difference in the sound pressure level between the middle frequency audio component and the low frequency audio component or the high frequency audio component.

In the present preferred embodiment, when the information processing is started in the control portion 45, the display processing portion 451, by controlling the display portion 41, simultaneously displays the second selection reception portion Op4 in the first display region R1 within the screen F, together with the switching reception portion Op1 and the selection reception portion Op2.

The display processing portion 451, when displaying the selection reception portion Op2 in a state of optimization "OFF" at the time of starting the information processing or when changing the display of the selection reception portion Op2 from "ON" to "OFF" according to the selection instruction by a user, in the same first display region R1, fixes the display of the second selection reception portion Op4 to automatic loudness "OFF" (that is, a change to automatic loudness "ON" is disabled. See FIG. 8(A)).

In addition, the display processing portion 451, when displaying the selection reception portion Op2 in a state of optimization "ON" at the time of starting the information processing or when changing the display of the selection reception portion Op2 from "OFF" to "ON" according to the selection instruction by a user, in the same first display region R1, displays the second selection reception portion Op4 in a state in which automatic loudness "ON" or "OFF" is able to be selected (see FIG. 8(B)).

On any of the screens F shown in FIGs. 8(A) and (B), when automatic loudness "OFF" is selected in the second selection reception portion Op4, manual adjustment of the loudness correction value becomes effective. For example, in the signal processing device 1, operation to the operation reception portion 17 (such as a dial for loudness volume adjustment, for example) becomes effective. It is to be noted that the manual adjustment of the loudness correction value may be performed on the screen F or another screen in the information processing device Z.

On the other hand, as the screen F shown in FIG. 8(B), when automatic loudness "ON" is selected in the second selection reception portion Op4, the loudness correction is automatically performed and the manual adjustment of the loudness correction value is disabled. In other words, in the signal processing device 1, operation to the operation reception portion 17 (such as a dial for loudness volume adjustment, for example) becomes disabled.

According to the information processing device Z of the present preferred embodiment, the second selection reception portion Op4 that receives a selection of whether or not loudness correction is automatically performed is collectively displayed on the same screen F (the user interface) for reproduction settings, together with the switching reception portion Op1 and the selection reception portion Op2. Therefore, a user can easily perform, on one screen F, an input (an input from the second selection reception portion Op4) of a selection instruction to select whether or not loudness correction is automatically performed, in addition to an input (an input from the switching reception portion Op1) of a switching instruction and an input (an input from the selection reception portion Op2) of a selection instruction.

### [3] Other Preferred Embodiments

In the information processing device Z stated above, in the first display region R1 within the screen F, not only the switching reception portion Op1 and the selection reception portion Op2 but also a reception portion for various settings that is preferably always displayed may be displayed. In addition, in the second display region R2 within the screen F, not only a case in which the detailed setting reception portion Op3 is selectively displayed but also a reception portion for various settings (other detailed settings included in the optimal setting Ia, for example) may be selectively displayed.

Finally, the foregoing present preferred embodiment is illustrative in all points and should not be construed to limit the present invention. The scope of the present invention is defined not by the foregoing preferred embodiment but by the following claims. Further, the scope of the present invention is intended to include all modifications within the scopes of the claims and within the meanings and scopes of equivalents.

### Reference Signs List

- 1: signal processing device
- 3: microphone
- Z: information processing device
- F: screen
- 11: input portion
- 12: obtaining portion
- 13: output portion
- 14: switching execution portion
- 15: storage portion
- 16: signal processing portion
- 17: operation reception portion
- 18: control portion
- 19: communication portion
- 21L, 21R: speaker
- 22L, 22R: speaker
- 41: display portion
- 42: input portion
- 43: communication portion
- 44: storage portion
- 45: control portion
- 451: display processing portion
- 452: communication processing portion
- Op1: switching reception portion
- Op2: selection reception portion
- Op3: detail setting reception portion
- Op4: second selection reception portion
- Ia: optimal setting
- Id: default setting
- Pa: listening position
- R1: first display region
- R2: second display region
- Sin: input audio signal
- Sout: output audio signal

## Claims

1. An information processing device comprising:
a display processing portion that is configured to display simultaneously on a same screen:
a switching reception portion that is configured to receive switching of a speaker to be a supply destination of a signal from a signal processing device, and
a selection reception portion that is configured to receive a selection about whether or not characteristics of the speaker to be selected by the switching received by the switching reception portion are optimized; and
a communication processing portion that is configured to transmit instructions for various settings received by the switching reception portion and the selection reception portion to the signal processing device.

2. The information processing device according to claim 1, wherein the display processing portion is configured to,
when the selection to optimize the characteristics of the speaker is received by the selection reception portion, display a detailed setting reception portion that receives a change of at least one detailed setting included in an optimal setting for optimization, on the same screen that displays the switching reception portion and the selection reception portion, and,
when the selection not to optimize the characteristics of the speaker is received by the selection reception portion, hide or disable the detailed setting reception portion on the screen.

3. The information processing device according to claim 1 or 2, wherein the display processing portion is configured to display a second selection reception portion that receives a selection about whether or not loudness correction is automatically performed, simultaneously on the same screen with the switching reception portion and the selection reception portion.

4. An information processing method comprising:
displaying simultaneously on a same screen:
a switching reception portion that is configured to receive switching of a speaker to be a supply destination of a signal from a signal processing device, and
a selection reception portion that is configured to receive a selection about whether or not characteristics of the speaker to be selected by the switching received by the switching reception portion are optimized; and
transmitting instructions for various settings received by the switching reception portion and the selection reception portion to the signal processing device.

5. A program to cause an information processing device to execute:
a display step of displaying simultaneously on a same screen:
a switching reception portion that is configured to receive switching of a speaker to be a supply destination of a signal from a signal processing device, and
a selection reception portion that is configured to receive a selection about whether or not characteristics of the speaker to be selected by the switching received by the switching reception portion are optimized; and
a communication step of transmitting instructions for various settings received by the switching reception portion and the selection reception portion to the signal processing device.
